# EUROPÄISCHE PATENTSCHRIFT

(11) **EP 2 285 197 B1**
(45) Veröffentlichungstag und Bekanntmachung des Hinweises auf die Patenterteilung: **05.03.2014**
(21) Anmeldenummer: 10002908.1
(22) Anmeldetag: 19.03.2010
(51) Int. Cl.: H05K 1/18, H05K 3/32, H05K 3/34

(54) **Verfahren zur Verbindung eines elektronischen Bauteils mit einer Leiterplatte**
Method for connecting an electronic component with a circuit board
Procédé de raccordement d'un composant électrique et d'une plaquette

(30) Priorität: 17.07.2009 DE 102009033650
(43) Veröffentlichungstag der Anmeldung: 16.02.2011
(73) Patentinhaber: Automotive Lighting Reutlingen GmbH, 72762 Reutlingen (DE)
(72) Erfinder: Ripple, Heiko, 72768 Reutlingen (DE); Gabler, Lutz, 46562 Voerde (DE); Hiegler, Michael, 72760 Reutlingen (DE); Herter, Helmut, Dipl.-Ing. (FH), 72793 Pfullingen (DE)
(74) Vertreter: DREISS Patentanwälte PartG mbB

(56) Entgegenhaltungen:
- DE-B- 1 765 252
- JP-A- 2 148 794
- JP-A- 5 160 550
- JP-A- 2005 347 415
- US-A- 3 881 245

## Beschreibung

Die vorliegende Erfindung betrifft ein Verfahren zur Verbindung eines elektronischen Bauteils mit einer Leiterplatte nach dem Oberbegriff des Anspruchs 1.

Mit Blick auf ihre Vorrichtungsaspekte betrifft die Erfindung darüber hinaus eine Baugruppe mit einer Leiterplatte, wenigstens einem elektronischen Bauteil und einer elektrisch leitfähigen Verbindung von wenigstens einem elektrischen Kontakt der Leiterplatte mit wenigstens einem elektrischen Kontakt des elektronischen Bauteils nach dem Oberbegriff des Anspruchs 6.

Ein solches Verfahren und eine solche Baugruppe ist jeweils aus der US 3,881,245 bekannt. Dort wird beschrieben, Metallfolienstücke an Kontaktflächen der Leiterplatte anzuschweißen und dann die verbliebenen Enden dieser Metallfolienstücke schließlich an metallisierten Anschlussflächen anzuschweißen.

Nach der DE 1 765 252 werden zur Verbindung eines elektrischen Bauteils mit einer gedruckten Schaltung die folgenden Schritte durchgeführt: Anschließen eines goldplattierten Verbindungsteils (Draht oder Streifen) an ein Ende eines Bauteils, Anschweißen eines Stücks einer Goldfolie an die Schaltung, Anschweißen des anderen Endes des Verbindungsteils an das Stück Goldfolie. Die Verbindung erfolgt hier demnach über zwei Teile, nämlich ein Verbindungsteil und ein Stück Goldfolie. Die jeweils beteiligten Fügepartner werden dabei jeweils miteinander verschweißt.

Soweit es um das elektrische Verbinden einer Hybridschaltungs-Leiterplatte mit einem Eingangs- oder Ausgangsanschluss an einem Schaltungsgehäuse geht, ist es aus der JP 02148794 bekannt, einen mit Ni, Sn oder einem anderen Lot belegten Anschlussdraht mit einem Gehäusekontakt mit Hilfe von zwei Schweißelektroden elektrisch zu Verschweißen. Dadurch soll eine bei hohen und tiefen Temperaturen zuverlässig leitende Verbindung erzeugt werden, die sich nicht selbst löst.

Bei der vorliegenden Erfindung geht es um die Verbindung eines elektronischen Bauteils mit einer Leiterplatte. Bei dem Bauteil handelt es sich zum Beispiel um eine LED (light emitting diode) in einer Beleuchtungseinrichtung eines Kraftfahrzeugs. Dabei dient die flexible Leiterplatte zur Verbindung von LED und zugehöriger Steuer- und/oder Leistungselektronik. Eine Verbindung der LED mit der Leiterplatte könnte dabei im Prinzip mit Steckverbindungen erfolgen. Steckverbindungen sind jedoch grundsätzlich in der Fahrzeugumgebung fehleranfällig und sollten daher vermieden werden.

Einige Bauteile wie LED mit vergleichsweise geringer Leistung können direkt mit der flexiblen Leiterplatte verlötet werden. Dies gilt z.B. dann, wenn die im Betrieb dieser Bauteile auftretende Verlustwärme direkt durch die flexible Leiterplatte oder mit Hilfsmaßnahmen abgeführt werden kann.

Im Gegensatz dazu benötigen z.B. Hochleistungs-LED wegen ihrer stärkeren Wärmeentwicklung einen direkten thermischen Kontakt zu einem Kühlkörper. Durch diesen direkten thermischen Kontakt mit dem vergleichsweise großen und schweren Kühlkörper sind die Hochleistungs-LED daher den starren Schaltungsteilen zuzurechnen.

Bisher werden die LED durch einen Thermoden-Lötprozess mit der flexiblen Leiterplatte verbunden. Thermodenlöten (Bügellöten) wird in der Kraftfahrzeugelektronik allgemein zur Verbindung von flexiblen Leiterplatten mit starren Schaltungsteilen und/oder starren Bauelementen verwendet.

Dabei erzeugt ein stromdurchflossenes Werkzeug, die Thermode, Wärme. Darüber hinaus überträgt die Thermode die Wärme über Kontaktdruck auf das Werkstück. Die Thermode heizt sich innerhalb einer programmierten Zeit auf eine programmierte Prozesstemperatur auf, die dann für eine programmierte Prozesszeit gehalten wird. Nach Ablauf der Prozesszeit kühlt die Thermode ab und hebt sich bei einer vorbestimmten Temperatur von der Lötstelle ab, bei der das Lot an der Fügestelle sicher erstarrt ist.

Mit Blick auf eine zulässige thermische Belastung ist der Thermode-Lötprozess für die LED unkritisch. Nachteilig ist jedoch, dass der Thermode-Lötprozess im bestehenden Herstellungsprozess einen Flaschenhals darstellt.

Ein alternatives Verfahren und eine alternative Vorrichtung der eingangs genannten Art ist jeweils aus der EP 1 186 370 B1 bekannt. Bei dem bekannten Verfahren wird eine Laserschweißverbindung zwischen einer flexiblen Metallfolie, insbesondere einer Cu-Folie, und einem metallischen Kontaktpartner erzeugt. Als wichtiges Anwendungsgebiet wird dort die automatisierte Bestückung einer flexiblen Leiterplatte mit elektronischen Bauelementen genannt, wobei die Metallfolie die Leiterbahnen realisiert und Kontaktstifte der Bauelemente die metallischen Kontaktpartner darstellen. Die Leiterplatte ist dabei zwischen zwei Isolationsschichten eingebettet. An den geplanten Kontaktstellen zwischen der Leiterplatte und den Kontaktstiften wird wenigstens eine der Isolationsschichten geöffnet und die Leiterplatte wird mit ihren geöffneten Bereichen durch eine Handhabungsvorrichtung so gegen die ortsfesten Kontaktstifte gedrückt, dass die Kontaktstifte durch die erzeugten Öffnungen hindurch die Metallfolie der Leiterplatte berühren. Dieses Andrücken erfolgt für jeden Kontaktstift mit Hilfe eines federbelasteten rohrförmigen Niederhalters, der exakt axial zu dem jeweils gegenüber liegenden Metallstift ausgerichtet ist. Zum Herstellen der Schweißverbindung schmilzt ein Laserstrahl die Fügepartner ggf. durch die Rohröffnung des Niederhalters und ggf. durch die Isolationsschicht hindurch bis in eine Tiefe von ca. 1 mm auf und erzeugt damit einen Schweißpunkt von etwa 0,6 bis 0,9 mm Durchmesser.

Bei diesem Stand der Technik wird die Leiterbahn oder Metallfolie der Leiterplatte damit direkt mit dem Fügepartner, dort einem Kontaktstift, verschweißt. Die Materialstärken der Fügepartner sind stark unterschiedlich: Die Kontaktstifte sind im Vergleich zur Metallfolie voluminöser. Es besteht daher die Gefahr, dass beim Aufschmelzen des Kontaktstiftes bereits Material der Leiterbahn verdampft, was die mechanischen und/oder elektrischen Eigenschaften des Schweißpunktes nachteilig beeinflussen kann. Das Zusammentreffen einer dünnen Folie mit einem kleinen Schweißpunkt ergibt stets eine unerwünscht geringe Festigkeit. In diesem Zusammenhang ist es erwähnenswert, dass die Beschreibung der EP 1 186 370 B1 Einschränkungen bei der Materialauswahl der Kontaktstifte enthält, um nicht reproduzierbare Schweißergebnisse durch ein zu eruptives Werkstoffverhalten zu vermeiden. Bei diesem Verfahren tritt neben dem genannten Problem mit der Kontaktsicherheit der Verbindung auch das Problem auf, dass für den verdampften Kunststoff der flexiblen Leiterplatte zusätzliche Sicherheitsmassnahmen ergriffen werden müssen.

Mit Blick auf eine zuverlässige Funktion der Verbindung im späteren Betrieb der Leiterplatte und der Bauteile ist die Prozesssicherheit, also die Reproduzierbarkeit der erzielten Ergebnisse eminent wichtig. Dies gilt insbesondere bei Anwendungen, bei denen viele Bauteile an eine Leiterplatte angeschlossen werden. Dies ist zum Beispiel bei Leuchteinheiten von Kraftfahrzeugen der Fall, bei denen eine Vielzahl von Bauelementen in Form von LEDs an eine flexible Leiterplatte angeschlossen werden und bei denen die LEDs und/oder Verbindungen nach der Herstellung der Leuchteinheit nicht mehr zugänglich sind. Da die Leuchteinheit unter Umständen dann bereits bei einer einzelnen fehlerhaften Schweißverbindung als ganzes fehlerhaft ist, wirken sich bereits einzelne Fehler stark kostentreibend aus.
Ferner erfordert eine zuverlässige Funktion bei vielen Anwendungen hohe Abzugszugfestigkeiten, also eine hohe mechanische Festigkeit der Verbindungen zwischen Leiterplatte und Bauteil. Wichtig ist häufig auch eine möglichst hohe Temperaturbeständigkeit und eine hohe Vibrationsfestigkeit. Auch dies sind typische Anforderungen, die bei Leuchteinheiten in Kraftfahrzeugen auftreten.

Vor diesem Hintergrund besteht die Aufgabe der Erfindung in der Angabe eines Verfahrens der eingangs genannten Art, mit dem sich elektronische Bauteile mit hoher mechanischer Anschlussfestigkeit und hoher Temperaturbeständigkeit prozesssicher und damit mit geringer Ausschussrate an Leiterplatten anschließen lassen, wobei viele Bauteile an eine Leiterplatte anzuschließen sind. Mit Blick auf ihre Vorrichtungsaspekte besteht die Aufgabe der Erfindung in der Angabe einer Baugruppe mit Verbindungen, die diese Eigenschaften besitzen.

Diese Aufgabe wird jeweils mit den Merkmalen der unabhängigen Ansprüche gelöst.

Das erfindungsgemäße Verfahren zeichnet sich also dadurch aus, dass mehrere mit einem Kunststoffsteg verbundenen Verbindungselemente einmal mit einem Niederhalter für mehrere Schweißpunkte fixiert werden.

Die erfindungsgemäße Baugruppe zeichnet sich dadurch aus, dass zwei oder mehr Verbindungselemente mit einem Kunststoffsteg verbunden sind.

Die Erfindung gewährleistet die Einhaltung definierter Abstände der einzelnen Verbindungselemente voneinander und verhindert damit Kurzschlüsse. Damit kann die Bestückung beschleunigt werden. Die Verbindungselemente besitzen immer einen konstanten Abstand der Kontakte, was vorteilhaft für das Laserschweißen ist. Ein besonderer Vorteil der Einbettung der Verbindungselemente in einen gemeinsamen Kunststoffsteg liegt darin, dass mit einem Teil, nämlich dem Verbundteil aus dem Kunststoffsteg und den daran befestigten Verbindungselementen alle elektrischen Verbindungen hergestellt werden können, sofern alle erforderlichen Verbindungselemente in das Verbundteil integriert sind. Das Merkmal, dass die mit dem Kunststoffsteg verbundenen Verbindungselemente für die Laserschweißung mit einem Niederhalter einmal für mehrere Schweißpunkte fixiert werden können, beschleunigt die Bestückung ebenfalls und reduziert die Prozesszeiten damit weiter.

Die Baugruppe weist anschließend elektrisch leitfähige Verbindungen auf, die jeweils ein Verbindungselement aufweisen, das mit dem elektrischen Kontakt der Leiterplatte elektrisch leitend und stoffschlüssig verbunden ist und das mit einem elektrischen Kontakt des elektronischen Bauteils verschweißt ist, wobei das Verbindungselement in Bezug auf seine Materialzusammensetzung und/oder seine Abmessungen einen Kompromiss zwischen den Materialzusammensetzungen und/oder Abmessungen von Kontakten der Bauelemente und der Leiterplatte darstellt.

Mit dem Verbindungselement wird gewissermaßen ein weiterer Fügepartner zwischen die Leiterplatte und die Bauelemente geschaltet. Der weitere Fügepartner stellt von seiner Materialzusammensetzung und seinen Abmessungen her einen Kompromiss zwischen den Materialzusammensetzungen und/oder Abmessungen von Kontakten der Bauelemente und der Leiterplatte dar. Dadurch lässt sich insbesondere die Qualität der Schweißstellen hinsichtlich ihrer elektrischen Eigenschaften, ihrer Temperaturbeständigkeit und ihrer Abzugsfestigkeit verbessern. Zum Beispiel kann die Materialstärke des Verbindungselements von Anwendung zu Anwendung variieren. Außerdem können Verbindungselemente mit an beiden Seiten ungleichen Materialquerschnitten verwendet werden.

Im Vergleich zum Lötprozess ist das Schweißen wesentlich schneller. Bevorzugt wird ein Laserschweißprozess. Beim Laserschweißen wird kurzzeitig mit hoher Leistung das zu verschweißende Material aufgeschmolzen. Da die Energie nur in ein lokal kleines Volumen eingekoppelt wird fließt die Wärme vom Schweißbereich sehr schnell ab, was zu einem schnellen Erstarren der Schmelze und zu hohen Prozessgeschwindigkeiten führt. Andere Schweißverfahren wie das Elektropunktschweißen werden dagegen als weniger geeignet betrachtet, da sie zur Zerstörung der LED führen können.

Die Bestückung der Leiterplatte mit den Verbindungselementen kann räumlich und zeitlich getrennt vom Verschweißen der metallischen Anschlussflächen der Bauelemente mit den Verbindungselementen erfolgen, so dass die zum Anschweißen der Kontakte der Bauelemente an die Leiterplatte erforderliche Zeit nicht vergrößert wird. Die für eine rationelle Fertigung hohe Taktfrequenz, die für Schweißvorgänge höher liegt als für Lötvorgänge, kann daher beibehalten werden.

Bei dem vorgeschlagenen Verfahren wird demnach zunächst die flexible Leiterplatte mit den Verbindungselementen bestückt. Im zweiten Schritt werden die mit der flexiblen Leiterplatte verbundenen Verbindungselemente an der LED, bzw. dem Bauteil festgeschweißt. Die Bestückung der Leiterplatte mit den Verbindungselementen kann in einem Vorbereitungsschritt alternativ durch Schweißen oder durch andere stoffschlüssige Verbindungstechniken wie Kleben mit leitfähigem Kleber oder Löten erfolgen.

Die Bestückung erfolgt bevorzugt so, dass die blanken Verbindungselemente über den Rand der Leiterplatte hinausragen.

Dies ermöglicht ein Einbringen der für den Schweißvorgang erforderlichen Wärme direkt in das Verbindungselement, so dass die entstehende Schweißverbindung nicht durch Rückstände verbrannter Isolationslagen beeinträchtigt wird und ohne dass ein zusätzlicher Arbeitsschritt zum Entfernen von Isolationslagen vor dem Schweißen erforderlich ist.

Weitere Vorteile ergeben sich aus den abhängigen Ansprüchen, der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung werden in der Zeichnung dargestellt und in der nachfolgenden Beschreibung näher erläutert. Es zeigen, jeweils in schematischer Form:
- Fig. 1: einen Schnitt durch ein Ausführungsbeispiel einer erfindungsgemäßen Baugruppe;
- Fig. 2: erste Ausgestaltungen von Verbindungselementen für bestimmte Einbaulagen;
- Fig. 3: eine weitere Ausgestaltung von Verbindungselementen für bestimmte Einbaulagen;
- Fig. 4: eine Ausgestaltung eines Verbindungselements mit verringerter Wärmeübertragung; und
- Fig. 5: eine Ausgestaltung, bei der mehrere Verbindungselemente miteinander verbunden sind.

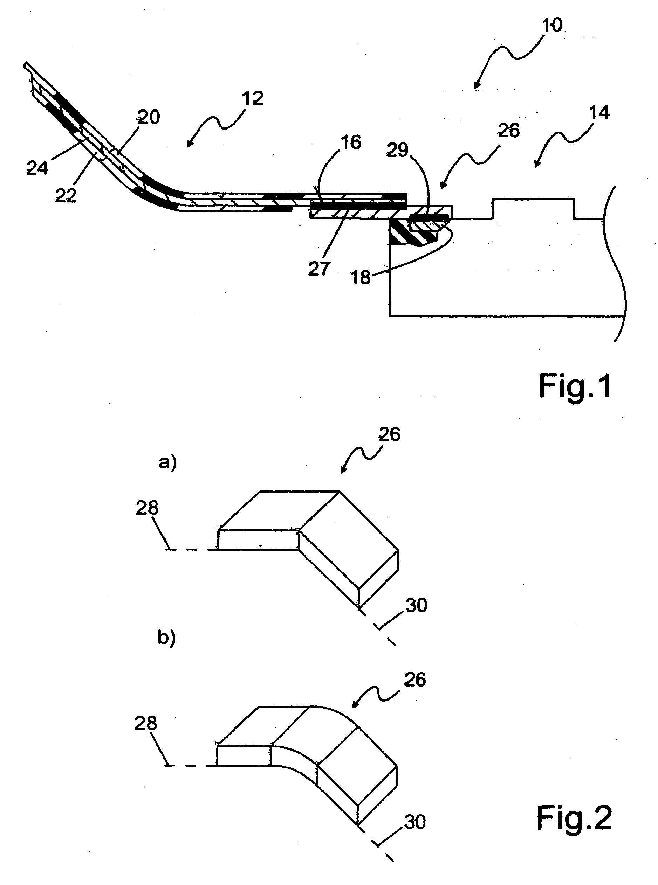

Im einzelnen zeigt die Fig. 1 eine Baugruppe 10 mit einer Leiterplatte 12, wenigstens einem elektronischen Bauteil 14 und einer elektrisch leitfähigen Verbindung von wenigstens einem elektrischen Kontakt 16 der Leiterplatte 12 mit wenigstens einem elektrischen Kontakt 18 des elektronischen Bauteils 14. Bei dem elektronischen Bauteil 14 handelt es sich in einer Ausgestaltung um eine Leuchtdiode,
insbesondere um eine Leuchtdiode einer Leuchteinheit eines Kraftfahrzeugs. Bei derartigen Baugruppen ergeben sich besonders hohe Anforderungen an die Qualität der elektrischen Kontakte aufgrund der im Alltagsbetrieb auftretenden großen Strombelastungen,
Temperaturunterschiede und Vibrationen.

Bei der Leiterplatte 12 handelt es sich bevorzugt um eine flexible Leiterplatte. Bevorzugt ist auch, dass die Leiterplatte dazu eingerichtet ist, das Bauteil 14 mit einem das Bauteil 14 steuernden und/oder mit elektrischer Leistung versorgenden Steuergerät und/oder einem oder mehreren anderen Bauteilen zu verbinden. Dies gilt unabhängig davon, ob es sich um eine flexible oder um eine starre Leiterplatte handelt.

In der dargestellten Ausgestaltung besteht die flexible Leiterplatte 12 aus einem Verbund aufeinander liegender Folien, von denen eine elektrisch isolierende Grundfolie 20 und eine elektrisch isolierende Deckfolie 22 jeweils eine Seite einer metallischen Leiterschicht 24 abdecken, die durch Lithografie- und Ätzschritte in Leiterbahnen und zwischen den Leiterbahnen liegende nichtleitende Bereiche strukturiert worden ist. Die Materialstärke der metallischen Leiterschicht 24 beträgt in einer Ausgestaltung 35 Mikrometer.

Erfindungsgemäß weist die elektrisch leitfähige Verbindung der Leiterplatte 12 mit dem Bauteil 14 ein
Verbindungselement 26 auf, das mit dem elektrischen Kontakt 16 der Leiterplatte 12 durch eine elektrisch leitende Verbindung 27 stoffschlüssig verbunden ist und das mit einem elektrischen Kontakt 18 des elektronischen Bauteils 14 durch eine Schweißverbindung 29 verschweißt ist. In einer bevorzugten Ausgestaltung besteht das Verbindungselement 26 aus Kupfer oder aus einer KupferLegierung. Als alternative Materialien kommen insbesondere gut leitende und gut schweißbare sowie gut lötbare Metalle in Frage.

Das Verbindungselement 26 ist vorzugsweise dicker als die Dicke der Leiterschicht 24. Durch die größere Materialstärke des Verbindungselements 26 lässt sich die Schweißverbindung 29 mit größerer Abzugsfestigkeit, höherer Temperaturbeständigkeit und größerer Prozesssicherheit, d.h. größerer Reproduzierbarkeit auch bei schwankenden Prozessparametern, erzeugen.

In einer Ausgestaltung ist die elektrisch leitende Verbindung 27 des Verbindungselements 26 mit dem elektrischen Kontakt 16 der Leiterplatte 12 eine gelötete Verbindung. Das Herstellen der Lötverbindung erfolgt in einer Ausgestaltung durch einen Bestückungsautomaten in einem SMT-Prozess (Surface Mounted Technology).

In einer alternativen Ausgestaltung ist die elektrisch leitende Verbindung 27 des Verbindungselements 26 mit dem elektrischen Kontakt 16 der Leiterplatte 12 eine mit einem elektrisch leitfähigen Klebstoff geklebte Verbindung.

Eine weitere alternative Ausgestaltung sieht vor, dass die elektrisch leitende Verbindung 27 des Verbindungselements 26 mit dem elektrischen Kontakt 16 der Leiterplatte 12 eine geschweißte Verbindung ist.

Die Fig. 1 zeigt insbesondere eine Ausgestaltung, bei der die Verbindungselemente 26 als ebene Bauteile ausgeführt sind. Diese Ausgestaltung eignet sich beispielsweise dann, wenn die Ebene der Leiterplatte im Bereich der zur Kontaktierung vorgesehenen Lötpunkte in der Einbaulage parallel zu der Ebene der LED ist, in der sich die Kontakte befinden.

Ein besonderer Vorteil der Verbindungselemente liegt darin, dass sie eine flexible Anpassung der Verbindung zwischen Bauteilen und der flexiblen Leiterplatte an die jeweils herrschenden Bauraumbedingungen erlaubt. Diese Anpassung erfolgt zum Beispiel für Anwendungen in Scheinwerfern dadurch, dass die Verbindungselemente eine dem zur Verfügung stehenden Einbauraum im Scheinwerfer angepasste Form aufweisen.

Sie können nahezu beliebig geformt sein. In der Fig. 2a und in der Fig. 2b sind Ausgestaltungen von
Verbindungselementen 26 für Anwendungsfälle dargestellt, in denen die Ebene 28 der Leiterplatte 12 im Bereich der zur Kontaktierung vorgesehenen Lötpunkte in der vorgesehenen Einbaulage nicht parallel zu der Ebene 30 der LED ist, in der sich die Kontakte befinden. Diese Ausgestaltungen von Verbindungselementen 26 zeichnen sich durch eine abgewinkelte und/oder gebogene Form aus.

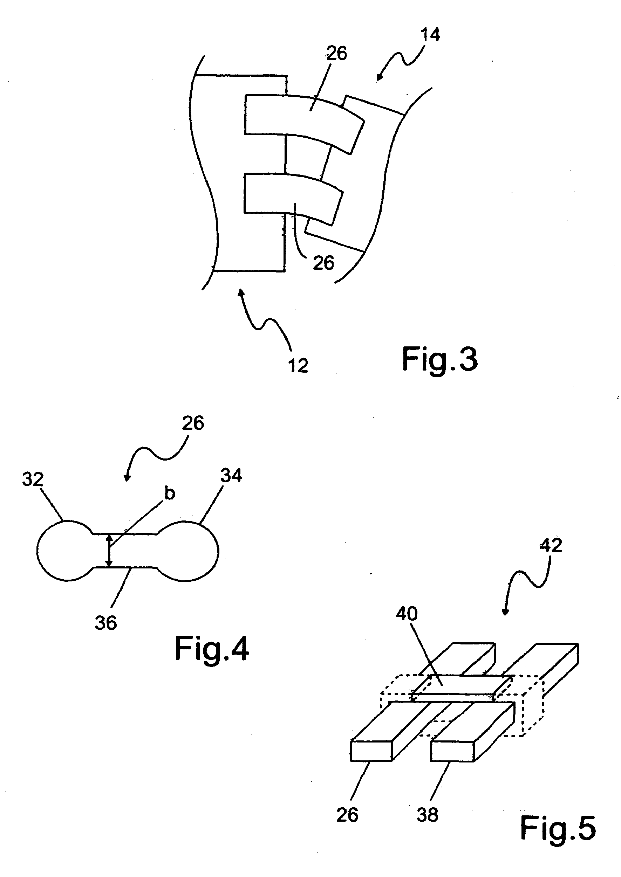

Mit den in Fig. 3 dargestellten Verbindungselementen 26, die eine Bogenform und unterschiedliche Längen besitzen, können Bauteile 14 wie LED derart an der Leiterplatte 12 befestigt werden, dass die Seite der Leiterplatte 12 mit den Anschlüssen für das jeweilige Bauteil 14 nicht parallel zu einer Anordnung der Kontakte des Bauteils 14 sein muss. Eine Ausgestaltung zeichnet sich daher dadurch aus dass die Verbindungselemente 26 eine Bogenform und/oder unterschiedliche Längen besitzen.

Fig. 4 zeigt eine Ausgestaltung, in der die
Verbindungselemente 26 die Form eines Hundeknochens besitzen. Hier sind beispielsweise zwei runde Kupferpads 32, 34, die höchstens die Größe der Lotpunkte beziehungsweise der Anschlusskontakte haben, einteilig mit einem dünnen Kupfersteg 36 verbunden. Dadurch wird ein guter elektrischer Kontakt bei geringer Wärmeübertragung von einem Bauteil 14 zur Leiterplatte 12 sichergestellt.

Dabei gilt ein Kupfersteg 36 als dünn, wenn seine Breite b kleiner als der Durchmesser der Kupferpads 32, 34 ist.

Fig. 5 zeigt eine weitere Ausgestaltung, bei der zwei oder mehr Verbindungselemente 26, 38 mit einem Kunststoffsteg 40 verbunden sind. Diese Ausgestaltung gewährleistet die Einhaltung definierter Abstände der einzelnen Verbindungselemente 26, 38 voneinander und verhindert damit Kurzschlüsse. Damit kann die Bestückung beschleunigt werden. Ferner wird durch den Kunststoffsteg 40 ein unkontrolliertes Abkippen der Verbindungselemente 26, 38 im noch flüssigen Lot direkt nach dem Auflöten auf der Leiterplatte 12 verhindert. Die Verbindungselemente 26, 38 besitzen immer einen konstanten Abstand der Kontakte, was vorteilhaft für das Laserschweißen ist. Die Verbindungselemente 26, 38 können sowohl zur Leistungsversorgung als auch zur Kontaktierung von Steuerungs- und Regelungsleitungen verwendet werden. Ein besonderer Vorteil der Einbettung der Verbindungselemente 26, 38 in einen gemeinsamen Kunststoffsteg 40 liegt darin, dass mit einem Teil, nämlich dem Verbundteil 42 aus dem Kunststoffsteg 40 und den daran befestigten Verbindungselementen 26, 38 alle elektrischen Verbindungen hergestellt werden können, sofern alle erforderlichen Verbindungselemente in das Verbundteil 42 integriert sind. Die mit dem Kunststoffsteg 40 verbundenen
Verbindungselemente 26, 38 können für die Laserschweißung mit einem Niederhalter einmal für mehrere Schweißpunkte fixiert werden, was die Prozesszeiten weiter reduziert. Der Kunststoffsteg 40 ist in einer weiteren Ausgestaltung ein Teil eines umlaufenden Bandes, was in der Fig. 5 als gestrichelte Fortsetzung des Kunststoffstegs 40 dargestellt ist. Dadurch wird die Prozesssicherheit weiter verbessert.

Eine weitere bevorzugte Ausgestaltung zeichnet sich dadurch aus, dass die Verbindungselemente 26, 38 eine den Lötprozess stabilisierende Beschichtung und/oder eine den Schweißprozess stabilisierende Beschichtung aufweisen. Für den Lötprozess kommt in einer Ausgestaltung eine Beschichtung mit dem Lot oder einer Lot und/oder Flussmittel enthaltenden Schicht in Frage. Für den Schweißprozess kommt insbesondere eine Beschichtung in Frage, die das Absorptionsvermögen des betreffenden Kontaktes für das verwendete Laserlicht erhöht.

In einer bevorzugten Ausgestaltung des Verfahrens zur Verbindung des elektronischen Bauteils 14 mit der Leiterplatte 21 werden zunächst die benötigten Verbindungselemente 26, 38 mit den elektrischen Kontakten 16 der Leiterplatte 12 in einem ersten Schritt elektrisch leitend und stoffschlüssig verbunden. Wie bereits erwähnt wurde, kann dies alternativ durch Löten, Kleben oder Schweißen erfolgen.

Anschließend werden die mit der Leiterplatte 12 verbundenen Verbindungselemente 26 in einem weiteren Fertigungsschritt mit den elektrischen Kontakten 18 der elektronischen Bauteile 14 verschweißt. Das Verschweißen erfolgt bevorzugt durch Laserschweißen oder Punktschweißen von der dem Bauteil 14 abgewandten Seite des Verbindungselements 26 aus, in der Fig. 1 also von oben. Dabei ist besonders vorteilhaft, dass das der Leiterplatte 12 abgewandte rechte Ende des Verbindungselements 26 blank nach rechts von der Leiterplatte 12 absteht, so dass ein direkter Wärmeeintrag, sei es durch einen Laser oder durch elektrischen Schweißstrom, möglich ist.

Durch seine Vorteile eignet sich das Verfahren insbesondere zur Herstellung von mit LEDs ausgerüsteten Leuchteinheiten von Kraftfahrzeugen, bei denen die Baugruppe 10 eine flexible Leiterplatte 12, eine Mehrzahl von elektronischen Bauteilen 14 in Form von LEDs und elektrisch leitfähigen Verbindungen von elektrischen Kontakten 16 der Leiterplatte 12 mit wenigstens einem elektrischen Kontakt 18 jeder LED aufweist, wobei die elektrisch leitfähige Verbindung jeweils ein Verbindungselement 26 aufweist, das mit jeweils einem elektrischen Kontakt 16 der Leiterplatte 12 elektrisch leitend und stoffschlüssig verbunden ist und dass mit einem elektrischen Kontakt 18 der LED 14 verschweißt ist.

Eine besonders bevorzugte Ausgestaltung des Verfahrens wird daher im Rahmen eines Verfahrens der Herstellung einer solchen Leuchteinheit durchgeführt.

## Patentansprüche

1. Verfahren zur Verbindung eines elektronischen Bauteils (14) mit einer Leiterplatte (12), wobei die Verbindung über ein Verbindungselement (26) erfolgt, das mit einem elektrischen Kontakt (16) der Leiterplatte (12) elektrisch leitend und stoffschlüssig verbunden wird und das mit einem elektrischen Kontakt (18) des elektronischen Bauteils (14) verschweißt wird, **dadurch gekennzeichnet, dass** mehrere mit einem Kunststoffsteg (40) verbundene Verbindungselemente (26, 38) einmal mit einem Niederhalter für mehrere Schweißpunkte fixiert werden.

2. Verfahren nach Anspruch 1, **dadurch gekennzeichnet, dass** das Verschweißen durch Laserschweißen erfolgt.

3. Verfahren nach Anspruch 1 oder 2, **dadurch gekennzeichnet, dass** das Verbindungselement (26) mit dem elektrischen Kontakt (16) der Leiterplatte (12) verlötet wird.

4. Verfahren nach Anspruch 1 oder 2, **dadurch gekennzeichnet, dass** das Verbindungselement (26) mit dem elektrischen Kontakt (16) der Leiterplatte (12) verschweißt wird.

5. Verfahren nach Anspruch 1 oder 2, **dadurch gekennzeichnet, dass** das Verbindungselement (26) mit dem elektrischen Kontakt (16) der Leiterplatte (12) mit einem elektrisch leitfähigen Klebstoff verklebt wird.

6. Baugruppe (10) mit einer Leiterplatte (12), wenigstens einem elektronischen Bauteil (14) und einer elektrisch leitfähigen Verbindung von wenigstens einem elektrischen Kontakt (16) der Leiterplatte (12) mit wenigstens einem elektrischen Kontakt (18) des elektronischen Bauteils (14), wobei die elektrisch leitfähige Verbindung ein Verbindungselement (26) aufweist, das mit dem elektrischen Kontakt (16) der Leiterplatte (12) elektrisch leitend und stoffschlüssig verbunden ist und das mit einem elektrischen Kontakt (18) des elektronischen Bauteils (14) verschweißt ist, **dadurch gekennzeichnet, dass** zwei oder mehr Verbindungselemente (26, 38) mit einem Kunststoffsteg (40) verbunden sind.

7. Baugruppe (10) nach Anspruch 6, **dadurch gekennzeichnet, dass** eine elektrisch leitende Verbindung (27) des Verbindungselements (26) mit dem elektrischen Kontakt (16) der Leiterplatte (12) eine gelötete oder geschweißte Verbindung ist.

8. Baugruppe (10) nach Anspruch 6, **dadurch gekennzeichnet, dass** eine elektrisch leitende Verbindung (27) des Verbindungselements (26) mit dem elektrischen Kontakt (16) der Leiterplatte (12) eine mit einem elektrisch leitfähigen Klebstoff geklebte Verbindung ist.

9. Baugruppe (10) nach einem der Ansprüche 6 bis 8, **dadurch gekennzeichnet, dass** die Verbindungselemente (26) als ebene Bauteile ausgeführt sind.

10. Baugruppe (10) nach einem der Ansprüche 6 bis 9, **dadurch gekennzeichnet, dass** die Verbindungselemente (26) eine Bogenform und/oder unterschiedliche Längen besitzen.

11. Baugruppe (10) nach einem der Ansprüche 6 bis 10, **dadurch gekennzeichnet, dass** die Verbindungselemente (26) die Form eines Hundeknochens besitzen.

12. Baugruppe (10) nach Anspruch 11, **dadurch gekennzeichnet, dass** zwei runde Kupferpads (32, 34), die höchstens die Größe der Lotpunkte und/oder Schweißpunkte an den Anschlusskontakten haben, einteilig mit einem Kupfersteg (36) verbunden sind, dessen Breite (b) kleiner als der Durchmesser der Kupferpads (32, 34) ist.

13. Baugruppe (10) nach einem der Ansprüche 6 bis 12, **dadurch gekennzeichnet, dass** die Verbindungselemente (26) eine den Lötprozess stabilisierende Beschichtung und/oder eine den Schweißprozess stabilisierende Beschichtung aufweisen.

14. Baugruppe (10) nach einem der Ansprüche 6 - 13, **dadurch gekennzeichnet, dass** die Leiterplatte (12) flexibel ist.

## Claims

1. A method for connecting an electronic component (14) to a printed circuit board (12), in which the connection is made via a connecting element (26) that is connected electrically conductively and in material-locking fashion to an electrical contact (16) of the printed circuit board (12) and is welded to an electrical contact (18) of the electronic component (14), **characterized in that** a plurality of connecting elements (26, 38) connected by a plastic bridging piece (40) are fixed once and for all to a holding-down device for a plurality of spot welds.

2. The method of claim 1, **characterized in that** the welding is done by laser welding.

3. The method of claim 1 or 2, **characterized in that** the connecting element (26) is soldered to the electrical contact (16) of the printed circuit board (12).

4. The method of claim 1 or 2, **characterized in that** the connecting element (26) is soldered to the electrical contact (16) of the printed circuit board (12).

5. The method of claim 1 or 2, **characterized in that** the connecting element (26) is glued to the electrical contact (16) of the printed circuit board (12) by means of an electrically conductive adhesive.

6. A component unit (10) having a printed circuit board (12), at least one electronic component (14), and an electrically conductive connection from at least one electrical contact (16) of the printed circuit board (12) to at least one electrical contact (18) of the electronic component (14), in which the electrically conductive connection has a connecting element (26) that is connected electrically conductively and in material-locking fashion to the electrical contact (16) of the printed circuit board (12) and is welded to an electrical contact (18) of the electronic component (14), **characterized in that** two or more connecting elements (26, 38) are connected by a plastic bridging piece (40).

7. The component unit (10) of claim 6, **characterized in that** an electrically conductive connection (27) of the connecting element (26) to the electrical contact (16) of the printed circuit board (12) is a soldered or welded connection.

8. The component unit (10) of claim 6, **characterized in that** an electrically conductive connection (27) of the connecting element (26) to the electrical contact (16) of the printed circuit board (12) is a connection glued by means of an electrically conductive adhesive.

9. The component unit (10) of one of claims 6 - 8, **characterized in that** the connecting elements (26) are embodied as flat components.

10. The component unit (10) of one of claims 6 - 9, **characterized in that** the connecting elements (26) have a curved shape and/or are of different lengths.

11. The component unit (10) of one of claims 6 - 10, **characterized in that** the connecting elements (26) are in the shape of a dog bone.

12. The component unit (10) of claim 11, **characterized in that** two round copper pads (32, 34), which at most are the size of the soldered spots and/or spot welds to the connection contacts, are connected in one piece to a copper bridging piece (36) whose width (b) is less than the diameter of the copper pads (32, 34).

13. The component unit (10) of one of claims 6 - 12, **characterized in that** the connecting elements (26) have a coating that stabilizes the soldering process and/or a coating that stabilizes the welding process.

14. The component unit (10) of one of claims 6 - 13, **characterized in that** the printed circuit board (12) is flexible.

## Revendications

1. Procédé de connexion d'un composant électronique (14) à une carte de circuits imprimés (12), la connexion étant réalisée par l'intermédiaire d'un élément de raccordement (26) qui est relié de manière électriquement conductrice et par liaison de matière à un contact électrique (16) de ladite carte de circuits imprimés (12) et qui est soudé sur un contact électrique (18) du composant électronique (14), **caractérisé par le fait que** plusieurs éléments de raccordement (26, 38) reliés par une entretoise en matière plastique (40) sont fixés une fois avec un dispositif de retenue pour plusieurs points de soudure.

2. Procédé selon la revendication 1, **caractérisé par le fait que** le soudage est réalisé par soudage au laser.

3. Procédé selon la revendication 1 ou 2, **caractérisé par le fait que** ledit élément de raccordement (26) est brasé sur le contact électrique (16) de la carte de circuits imprimés (12).

4. Procédé selon la revendication 1 ou 2, **caractérisé par le fait que** ledit élément de raccordement (26) est soudé sur le contact électrique (16) de la carte de circuits imprimés (12).

5. Procédé selon la revendication 1 ou 2, **caractérisé par le fait que** ledit élément de raccordement (26) est collé au moyen d'une colle électriquement conductrice sur le contact électrique (16) de la carte de circuits imprimés (12).

6. Ensemble (10) comprenant une carte de circuits imprimés (12), au moins un composant électronique (14) et une connexion électriquement conductrice d'au moins un contact électrique (16) de ladite carte de circuits imprimés (12) à au moins un contact électrique (18) du composant électronique (14), la connexion électriquement conductrice présentant un élément de raccordement (26) qui est relié de manière électriquement conductrice et par liaison de matière audit contact électrique (16) de ladite carte de circuits imprimés (12) et qui est soudé sur un contact électrique (18) du composant électronique (14), **caractérisé par le fait que** deux éléments de raccordement (26, 38) ou plus sont reliés par une entretoise en matière plastique (40).

7. Ensemble (10) selon la revendication 6, **caractérisé par le fait qu'**une connexion électriquement conductrice (27) entre ledit élément de raccordement (26) et ledit contact électrique (16) de la carte de circuits imprimés (12) est une connexion brasée ou soudée.

8. Ensemble (10) selon la revendication 6, **caractérisé par le fait qu'**une connexion électriquement conductrice (27) entre ledit élément de raccordement (26) et ledit contact électrique (16) de la carte de circuits imprimés (12) est une connexion collée réalisée au moyen d'une colle électriquement conductrice.

9. Ensemble (10) selon l'une quelconque des revendications 6 à 8, **caractérisé par le fait que** les éléments de raccordement (26) sont réalisés en tant que composants plans.

10. Ensemble (10) selon l'une quelconque des revendications 6 à 9, **caractérisé par le fait que** les éléments de raccordement (26) présentent une forme en arc et/ou des longueurs différentes.

11. Ensemble (10) selon l'une quelconque des revendications 6 à 10, **caractérisé par le fait que** les éléments de raccordement (26) présentent la forme d'un os à chien.

12. Ensemble (10) selon la revendication 11, **caractérisé par le fait que** deux disques ronds en cuivre (32, 34) qui présentent tout au plus la taille des points de brasage et/ou des points de soudure sur les contacts de raccordement sont reliés en une seule pièce à une entretoise en cuivre (36) dont la largeur (b) est inférieure au diamètre des disques en cuivre (32, 34).

13. Ensemble (10) selon l'une quelconque des revendications 6 à 12, **caractérisé par le fait que** les éléments de raccordement (26) présentent un revêtement stabilisant le processus de brasage et/ou un revêtement stabilisant le processus de soudage.

14. Ensemble (10) selon l'une quelconque des revendications 6 à 13, **caractérisé par le fait que** ladite carte de circuits imprimés (12) est flexible.
